Europäisches Patentamt

European Patent Office

Office européen des brevets

(11) Veröffentlichungsnummer: **0 220 779**
**A2**

## (12) EUROPÄISCHE PATENTANMELDUNG

(21) Anmeldenummer: 86201871.0

(22) Anmeldetag: 24.10.86 ·

(51) Int. Cl.4: **H03K 17/687**

(30) Priorität: 30.10.85 DE 3538552

(43) Veröffentlichungstag der Anmeldung:
06.05.87 Patentblatt 87/19

(84) Benannte Vertragsstaaten:
CH DE FR GB IT LI

(71) Anmelder: **Philips Patentverwaltung GmbH
Billstrasse 80
D-2000 Hamburg 28(DE) DE**
Anmelder: **N.V. Philips' Gloeilampenfabrieken
Groenewoudseweg 1
NL-5621 BA Eindhoven(NL) CHFRGBITLI**

(72) Erfinder: **Wegener, Armin Fritz
Kleinmarschierstrasse 61
D-5100 Aachen(DE)**
Erfinder: **Albach, Manfred, Dr.
Hasbach 5
D-5100 Aachen(DE)**

(74) Vertreter: **Poddig, Dieter et al
Philips Patentverwaltung GmbH Billstrasse
80 Postfach 10 51 49
D-2000 Hamburg 28(DE)**

(54) **Schaltungsanordnung zur Ansteuerung einer kapazitiven Last.**

(57) Die Erfindung betrifft eine Schaltungsanordnung mit einer einen Ausgangstransistor (2) enthaltenden Steuerschaltung (I), deren Ausgang der Kollektor des Ausgangstransistors (2) bildet. Der Kollektor ist über die Gate-Source-Strecke eines Sperrschicht-Feldeffekttransistors (5) und einem dazu parallel geschalteten Widerstand (6) mit der kapazitiven Last - (8) gekoppelt, und der Drain-Anschluß liegt an der Speisespannung (Ub).

EP 0 220 779 A2

Xerox Copy Centre

## Schaltungsanordnung zur Ansteuerung einer kapazitiven Last

Die Erfindung betrifft eine Schaltungsanordnung mit einer einen Ausgangstransistor enthaltenden Steuerschaltung, deren Ausgang der Kollektor des Ausgangstransistors bildet und die mit einer kapazitiven Last und mit einer Speisespannung gekoppelt ist.

Eine Steuerschaltung, deren Ausgang der Kollektor eines Ausgangstransistors ist, kann z.B ein Komparator sein, der mit einem oder mehreren Eingängen einer Logikschaltung z.B. in CMOS-Technik verbunden ist. Am Verbindungspunkt der beiden Schaltungen ist ein Widerstand an eine Speisespannung angeschlossen. Geht der Ausgangstransistor vom leitenden in den gesperrten Zustand über, steigt die Spannung am Eingang der CMOS-Schaltung auf ein höheres Potential. Aus dem Buch von Tietze/Schenk, Halbleiterschaltungstechnik, 5. Auflage, Seite 161 und 162 ist bekannt, daß der Spannungsanstieg durch die parasitären Kapazitäten der CMOS-Schaltung und den an die Speisespannung angeschlossenen Widerstand bestimmt wird.

Da die bekannte Schaltungsanordnung z.B. bei der Detektierung von maximalen Spannungspegeln bei Überspannungsschutzschaltungen eingesetzt werden kann, ist es erforderlich, daß die CMOS-Schaltung schnell auf Fehler, die von der Schutzschaltung detektiert werden, reagiert. Durch die vorgegebene Kapazität der CMOS-Schaltung kann eine Veränderung des Spannungsanstiegs nur über eine Verkleinerung des Widerstandes erfolgen. Dadurch steigt aber der Strom durch den Ausgangstransistor, wenn sich dieser im leitenden Zustand befindet.

Der Erfindung liegt die Aufgabe zugrunde, eine Schaltungsanordnung der eingangs genannten Art so auszubilden, daß ein schneller Spannungsanstieg bei geringem Stromverbrauch erreicht wird.

Diese Aufgabe wird erfindungsgemäß dadurch gelöst, daß der Kollektor über die Gate-Source-Strecke eines Sperrschicht-Feldeffekttransistors und einem dazu parallel geschalteten Widerstand mit der kapazitiven Last gekoppelt ist und daß der Drain-Anschluß an der Speisespannung liegt.

Unter der Voraussetzung, daß der Spannungsanstieg bei der erfindungsgemäßen Schaltungsanordnung genauso schnell erfolgen soll wie bei der bekannten, ist der Stromverbrauch bei der erfindungsgemäßen Schaltungsanordnung durch den Sperrschicht-Feldeffekttransistor geringer. Beim Wechsel des Ausgangstransistors vom leitenden in den gesperrten Zustand verhält sich der Sperrschicht-Feldeffekttransistor im ersten Moment wie eine Stromquelle, da die Gate-Source-Spannung gleich Null ist und der Feldeffekttransistor selbstleitend ist. Durch die Aufladung der kapazitiven Last mit dem maximalen Drain-Source-Kurzschlußstrom wird die Drain-Source-Spannung immer kleiner, und der Feldeffekttransistor geht in den gesperrten Zustand über. Wechselt der Ausgangstransistor vom gesperrten in den leitenden Zustand, hat zuerst der Source-Anschluß des Feldeffekttransistors ungefähr das Potential der Speisespannung. Dadurch ist der Feldeffekttransistor gesperrt und die kapazitive Last wird über den Widerstand und den Ausgangstransistor entladen. Der Widerstandswert bestimmt dabei, wie schnell die Kapazität entladen wird. Die Entladung erfolgt dabei ungefähr so schnell, wie bei der bekannten Schaltungsanordnung.

Es sei erwähnt, daß aus der US-PS 37 49 945 eine Schaltungsanordnung zur Ansteuerung einer kapazitiven Last bekannt ist. Eine solche kapazitive Last soll eine MOS-Logikschaltung sein, der ein Stromverstärker und eine Treiberschaltung vorgeschaltet sind zur Anpassung der MOS-Schaltung an eine TTL-Schaltung. Die Treiberschaltung enthält an ihrem Ausgang einen Ausgangstransistor, dessen Kollektor einen Ausgangsanschluß bildet. An den Verbindungspunkt von Treiberschaltung und Stromverstärker ist eine gesteuerte Stromquelle angeordnet, die nur einen Strom liefert, wenn der Ausgangstransistor vom leitenden in den gesperrten Zustand wechselt. Die Stromquelle wird dabei durch einen Steuerimpuls angeschaltet. Die Schaltungsanordnung der US-PS 37 49 949 ist sehr viel komplizierter als die erfindungsgemäße Schaltungsanordnung aufgebaut, und außerdem muß der Schaltungsanordnung noch ein zusätzlicher Steuerimpuls für den Betrieb der Konstantstromquelle zugeführt werden.

In einer Weiterbildung der Erfindung ist vorgesehen, daß der Widerstand einstellbar ist.

Verwendet werden kann die erfindungsgemäße Schaltungsanordnung in einem Schaltnetzteil. Die in Schaltnetzteilen eingesetzten Schalttransistoren werden häufig von Logikschaltungen (z.B. CMOS-Schaltungen) angesteuert, die wiederum mit dem Kollektor eines Steuertransistors verbunden sind. Die erfindungsgemäße Schaltungsanordnung wird zwischen den Kollektor des Steuertransistors und die Logikschaltung gesetzt.

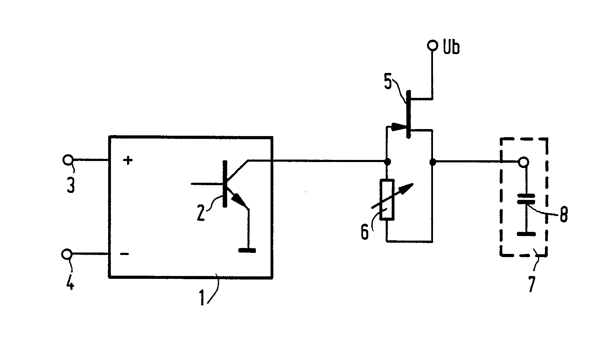

Anhand der einzigen in der Zeichnung dargestellten Figur wird die Erfindung näher erläutert. Eine Steuerschaltung I, die z.B. aus einem Komparator bestehen kann, enthält einen Ausgangstransistor 2, dessen Emitter an Masse geschaltet ist und dessen Kollektor einen Ausgangsanschluß bildet. Der Komparator I vergleicht ein Signal an einem Anschluß 3, das den nichtinvertierenden Eingang dieses Komparators bildet, mit einem Signal an einem Eingang 4, das den invertierenden Eingang bildet, und versetzt den Ausgangstransistor 2 entsprechend dem Vergleichsergebnis entweder in den gesperrten oder leitenden Zustand. Im gesperrten Zustand des Ausgangstransistors 2 ist die Ausgangsspannung größer als im leitenden Zustand.

Der Kollektor des Transistors 2 ist mit einem Gate-Anschluß eines N-Kanal-Sperrschicht-Feldeffekttransistors 5 verbunden. Der Drain-Anschluß dieses Transistors 5 ist an eine Speisespannung Ub angeschlossen. Zwischen dem Gate-Anschluß und dem Source-Anschluß des Feldeffekttransistors 5 liegt ein einstellbarer Widerstand 6. Des weiteren ist an den Source-Anschluß des Feldeffekttransistors 5 eine Logikschaltung 7 angeschlossen, die in CMOS-Technik aufgebaut ist und die eine kapazitive Last darstellt, die durch eine Kapazität 8 symbolisch dargestellt ist.

Wenn der Transistor 2 vom leitenden in den gesperrten Zustand geschaltet wird, ist zuerst der Sperrschicht-Feldeffekttransistor 5 selbstleitend und die Gate-Source-Spannung gleich Null. Da der Sperrschicht-Feldeffekttransistor 5 leitend ist, fließt der maximale Kurzschlußstrom des Feldeffekttransistors 5 aus der Speisespannung Ub in die Kapazität 8 hinein. Durch die stetige Aufladung der Kapazität 8 wird die Drain-Source-Spannung des Transistors 5 kleiner, der Drain-Strom wird geringer und der Transistor geht damit vom leitenden in den gesperrten Zustand über.

Wenn der Ausgangstransistor 2 vom sperrenden in den leitenden Zustand geschaltet wird, liegt zuerst der Source-Anschluß des Feldeffekttransistors 5 ungefähr auf dem Potential der Speisespannung Ub, da die Kapazität 8 auf diese Spannung aufgeladen wurde, während der Gate-Anschluß näherungsweise auf dem Massepotential liegt, da der Transistor 2 leitend ist. Durch diese hohe negative Gate-Source-Spannung ist der Feldeffekttransistor 5 fast vollständig gesperrt, und die Kapazität 8 entlädt sich über den Widerstand 6 bis zu einer bestimmten Gate-Source-Spannung, bei der zwischen Entladung und Aufladung durch die Speisespannung Ub ein Gleichgewichtszustand erreicht ist. Die sich im Gleichgewichtszustand einstellende Gate-Source-Spannung des Transistors 5 liegt unterhalb eines maximalen Wertes der Eingangsspannung der CMOS-Schaltung 7, bei der ein Zustandswechsel der CMOS-Schaltung erfolgen kann.

In praktischen Versuchen hat sich gezeigt, daß der Wert des Widerstandes 6 vorzugsweise zwischen l und 6 kOhm liegen sollte. Bei diesen Widerstandswerten erfolgt die Entladung der Lastkapazität ungefähr so schnell wie die Aufladung. Mit dem einstellbaren Widerstand 6 läßt sich der entsprechende Widerstandswert genau einstellen. Die Stromaufnahme bei der erfindungsgemäßen Schaltungsanordnung ist viel geringer als die bei der bekannten Schaltungsanordnung unter der Voraussetzung, daß die Aufladung in der gleichen Zeit erfolgt.

## Ansprüche

l. Schaltungsanordnung mit einer einen Ausgangstransistor (2) enthaltenden Steuerschaltung - (l), deren Ausgang der Kollektor des Ausgangstransistors (2) bildet und die mit einer kapazitiven Last (8) und mit einer Speisespannung (Ub) gekoppelt ist,

dadurch gekennzeichnet, daß der Kollektor über die Gate-Source-Strecke eines Sperrschicht-Feldeffekttransistors (5) und einem dazu parallel geschalteten Widerstand (6) mit der kapazitiven Last - (8) gekoppelt ist·und daß der Drain-Anschluß an der Speisespannung (Ub) liegt.

2. Schaltungsanordnung nach Anspruch 2,

dadurch gekennzeichnet, daß der Widerstand (6) einstellbar ist.

3. Verwendung der Schaltungsanordnung nach einem der vorhergehenden Ansprüche in einem Schaltnetzteil.